# EUROPEAN PATENT APPLICATION

(11) **EP 4 693 905 A1**
(43) Date of publication of application: **11.02.2026**
(21) Application number: 24795781.4
(22) Date of filing: 02.04.2024
(51) Int. Cl.: H03K 17/567

(54) **SWITCH AND DRIVE APPARATUS**

(30) Priority: 27.04.2023 CN 202310480701
(71) Applicant: Huawei Digital Power Technologies Co., Ltd., Shenzhen, Guangdong 518043 (CN)
(72) Inventor: XIAO, Bo, Shenzhen, Guangdong 518043 (CN); YAO, Wenhai, Shenzhen, Guangdong 518043 (CN); WANG, Liang, Shenzhen, Guangdong 518043 (CN)
(74) Representative: Isarpatent
(86) International application number: PCT/CN2024/085531
(87) International publication number: WO 2024/222400

(57) **Abstract**

This application provides a switch, including: a control circuit, configured to generate a low-voltage drive current; and a drive apparatus, including: a cable, configured to transmit the low-voltage drive current; at least one magnetic ring, where the magnetic ring is wound with a coil, the cable passes through the at least one magnetic ring, there is a gap between the magnetic ring and the cable, and the magnetic ring generates a high-voltage drive current based on the low-voltage drive current in the cable; an insulation layer, where the insulation layer wraps the cable; at least one shield structure, configured to shield an electromagnetic wave, where the at least one shield structure one-to-one corresponds to the at least one magnetic ring, the shield structure is embedded in the insulation layer, and each shield structure is located between a corresponding magnetic ring and the cable; and a thyristor, configured to switch between turning-on and turning-off based on the high-voltage drive current. A shield net is embedded in the insulation layer, to resolve a partial discharge problem of the air gap between the high-voltage magnetic ring and the low-voltage cable.

## Description

This application claims priority to Chinese Patent Application No. 202310480701.9, filed with the China National Intellectual Property Administration on April 27, 2023 and entitled "SWITCH AND DRIVE APPARATUS", which is incorporated herein by reference in its entirety.

### TECHNICAL FIELD

This application relates to the field of electrical control technologies, and more specifically, to a switch and a drive apparatus.

### BACKGROUND

A power component is an electronic component used to control or transmit high-power electric energy. Common power components include a transistor, a field effect transistor, a diode, a triode, a thyristor, and the like.

The power component may be referred to as a switch component. For example, the thyristor is connected to a load circuit, and a drive current is used to control turning-on and turning-off of the thyristor, to implement on/off control of an electrical device in the load circuit. The power component, for example, the thyristor has a high-voltage drive current, which is obtained by performing processing, for example, voltage boosting on a low-voltage control current. That is, a switch in the conventional technology has a low-voltage circuit part and a high-voltage circuit part.

How to reliably ensure electrical isolation between the high-voltage circuit part and the low-voltage circuit part, to avoid possible electric shock danger, device damage, signal interference, and the like becomes an urgent problem to be resolved in the industry.

### SUMMARY

This application provides a switch and a drive apparatus. The drive apparatus is an isolation transformer module in the switch. The isolation transformer module includes a high-voltage magnetic ring and a low-voltage cable that passes through the high-voltage magnetic ring. An insulation layer wraps a surface of the low-voltage cable that passes through the high-voltage magnetic ring, and a shield net is embedded in the insulation layer, to resolve a partial discharge problem of an air gap between the high-voltage magnetic ring and the low-voltage cable.

According to a first aspect, a switch is provided, including: a control circuit, configured to generate a low-voltage drive current; and a drive apparatus, including: a cable, configured to transmit the low-voltage drive current; at least one magnetic ring, where each magnetic ring is wound with a coil, the cable passes through the at least one magnetic ring, there is a gap between the magnetic ring and the cable, and the magnetic ring is configured to generate a high-voltage drive current based on the low-voltage drive current in the cable; an insulation layer, configured to wrap the cable; at least one shield structure, configured to shield an electromagnetic wave, where the at least one shield structure one-to-one corresponds to the at least one magnetic ring, the shield structure is embedded in the insulation layer, each shield structure is located between a corresponding magnetic ring and the cable, the shield structure and the cable are not in contact with each other, and there is the insulation layer between the shield structure and the cable; and a power component, configured to switch between turning-on and turning-off based on the high-voltage drive current.

Based on the foregoing technical solution, the low-voltage cable that passes through the high-voltage magnetic ring is sealed in the insulation layer, and the shield structure is embedded in the insulation layer, so that insulation performance of the insulation layer is enhanced, uniformity of an electric field in the air gap between the high-voltage magnetic ring and the low-voltage cable is improved, a partial discharge problem is resolved, insulation reliability of the drive apparatus is improved, electrical isolation between a high-voltage circuit part and a low-voltage circuit part is effectively ensured, and possible electric shock danger, device damage, signal interference are avoided.

With reference to the first aspect, in some implementations of the first aspect, the shield structure is equipotentially connected to the corresponding magnetic ring through a conducting wire.

Based on the foregoing technical solution, the shield structure is equipotentially connected to the high-voltage magnetic ring, so that a potential difference between a surface of the insulation layer and the high-voltage magnetic ring is reduced, an electric field in the air gap between the high-voltage magnetic ring and the low-voltage cable is changed, a partial discharge problem is resolved, and insulation reliability of the drive apparatus is improved.

In a possible implementation, a width of the shield structure in an axis direction of the cable is greater than a width of the magnetic ring in the axis direction of the cable.

In a possible implementation, a projection of the magnetic ring on the cable is within a projection of the shield structure on the cable.

In a possible implementation, the shield structure is an annular shield net made of a conductive metal material, and the shield structure surrounds the cable.

In a possible implementation, the insulation layer is formed by potting epoxy resin.

In a possible implementation, the power component includes a thyristor, a triode, a metal-oxide semiconductor field effect transistor, an insulated gate bipolar transistor, a relay, or the like.

According to a second aspect, a drive apparatus is provided, where the drive apparatus is configured to control turning-on and turning-off of a thyristor, and including: a cable, configured to transmit a low-voltage drive current; at least one magnetic ring, where each magnetic ring is wound with a coil, the cable passes through the at least one magnetic ring, there is a gap between the magnetic ring and the cable, and the magnetic ring is configured to generate a high-voltage drive current based on the low-voltage drive current in the cable; an insulation layer, configured to wrap the cable; at least one shield structure, configured to shield an electromagnetic wave, where the at least one shield structure one-to-one corresponds to the at least one magnetic ring, the shield structure is embedded in the insulation layer, and each shield structure is located between a corresponding magnetic ring and the cable; and a power component, configured to switch between turning-on and turning-off based on the high-voltage drive current.

Based on the foregoing technical solution, the low-voltage cable that passes through the high-voltage magnetic ring is sealed in the insulation layer, and the shield structure is embedded in the insulation layer, so that an electric field in the air gap between the high-voltage magnetic ring and the low-voltage cable is changed, a partial discharge problem is resolved, insulation reliability is improved, electrical isolation between a high-voltage circuit part and a low-voltage circuit part is effectively ensured, and possible electric shock danger, device damage, signal interference are avoided.

In a possible implementation, the shield structure is equipotentially connected to the corresponding magnetic ring through a conducting wire.

In a possible implementation, a width of the shield structure in an axis direction of the cable is greater than a width of the magnetic ring in the axis direction of the cable.

In a possible implementation, a projection of the magnetic ring on the cable is within a projection of the shield structure on the cable.

In a possible implementation, the shield structure is an annular shield net made of a conductive metal material, and the shield structure surrounds the cable.

In a possible implementation, the power component includes a thyristor, a triode, a metal-oxide semiconductor field effect transistor, an insulated gate bipolar transistor, a relay, or the like.

In a possible implementation, the insulation layer is formed by potting epoxy resin.

According to a third aspect, a data center is provided, including the switch according to any one of claims 1 to 5 and an electronic component controlled by the switch.

### BRIEF DESCRIPTION OF DRAWINGS

FIG. 1 is a diagram of a control system bus;
FIG. 2 is a diagram of an isolation drive circuit;
FIG. 3 is a diagram of an isolation drive circuit and an insulation structure of the isolation drive circuit;
FIG. 4 is a sectional view of an isolation drive circuit and an insulation structure of the isolation drive circuit along a cable axis;
FIG. 5 is a diagram of a switch according to this application;
FIG. 6 is a diagram of an isolation drive circuit and an insulation structure of the isolation drive circuit according to this application;
FIG. 7 is a sectional view of an isolation drive circuit and an insulation structure of the isolation drive circuit along a cable axis according to this application;
FIG. 8 is a sectional view of an isolation drive circuit and an insulation structure of the isolation drive circuit at a high-voltage magnetic ring along a cross section of a cable according to this application;
FIG. 9 is a diagram of another isolation drive circuit and an insulation structure of the another isolation drive circuit according to this application; and
FIG. 10 is a sectional view of another isolation drive circuit and an insulation structure of the another isolation drive circuit along a cable axis according to this application.

### DESCRIPTION OF EMBODIMENTS

The following describes technical solutions of this application with reference to accompanying drawings.

It should be understood that the specific embodiments described herein are merely used to explain this application, but are not intended to limit this application. In other words, the described embodiments are merely some but not all of embodiments of this application. Components in embodiments of this application that are generally described and illustrated in the accompanying drawings herein may be arranged and designed in various different configurations.

Therefore, the following detailed descriptions of embodiments of this application provided in the accompanying drawings are not intended to limit the scope of this application, but merely to represent selected embodiments of this application. All other embodiments obtained by a person skilled in the art based on embodiments of this application without creative efforts shall fall within the protection scope of this application.

It should be noted that, a term "include", "contain", or any other variant is intended to cover a non-exclusive inclusion, so that a process, a method, an object, or an apparatus that includes a series of elements not only includes those elements but also includes other elements that are not expressly listed, or further includes elements inherent to such a process, method, object, or apparatus.

It should be noted that similar reference numerals and letters represent similar items in the following accompanying drawings. Therefore, once an item is defined in one accompanying drawing, it does not need to be further defined and explained in the following accompanying drawings.

In this application, on/off of a high-voltage electronic component is controlled by controlling turning-on and turning-off of a power component. The power component herein may be referred to as a switch component. For example, a thyristor or another power component is connected to a load circuit, and on/off of a high-voltage electronic component in the load circuit is controlled by controlling turning on and turning off of the thyristor.

The power component, for example, the thyristor has a high-voltage drive current, which is obtained by boosting a low-voltage control current. That is, a switch has a low-voltage control circuit and a high-voltage load circuit, and electrical isolation needs to be performed between the high-voltage circuit and the low-voltage circuit, to avoid problems such as possible electric shock danger, device damage, and signal interference.

To drive the power component securely and reliably, an isolation drive circuit may be used as a drive circuit of the power component. The isolation drive circuit is a common drive circuit, and may be configured to control turning-on and turning-off of the power component, and can isolate a control circuit and a load circuit, to avoid impact of the load circuit on a control signal, and avoid mutual interference and damage between the control circuit and the load circuit, thereby improving security and stability of the circuit. The isolation drive circuit may be integrated in a switchgear of a data center.

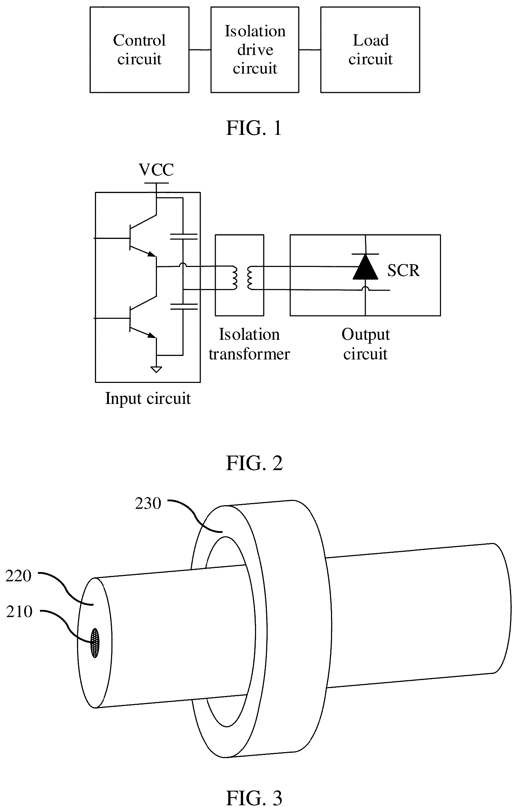

As shown in FIG. 1, the isolation drive circuit is located between the load circuit and the control circuit, and is an intermediate circuit configured to amplify a signal of the control circuit. Specifically, the isolation drive circuit receives a low-voltage control signal generated by the control circuit, and an isolation transformer isolates and converts the low-voltage control signal into a high-voltage drive current, to drive the power component, so as to control an electrical device in the load circuit connected to the power component. The isolation drive circuit may isolate the control circuit and the load circuit, to avoid impact of the load circuit on the control signal, protect mutual interference and damage between the control circuit and the load circuit, and improve security and stability of the circuit.

Specifically, the control circuit is configured to generate the low-voltage control signal, including a microcontroller, a pulse-width modulation (Pulse Width Modulation, PWM) conditioning circuit, and the like. The microcontroller is configured to generate a low-voltage control current, and the low-voltage control current is adjusted and optimized via the PWM conditioning circuit and then transferred to the isolation drive circuit. The microcontroller is an embedded system, integrates peripherals such as a microprocessor, a memory, and an input/output interface, has a complete computer system architecture, and can implement various control and processing tasks. The PWM conditioning circuit is an electronic circuit, and is mainly configured to control and adjust a duty cycle of a PWM signal, to precisely control on/off of the power component. The PWM conditioning circuit generally includes a comparator, a counter, a latch, and a filter. A basic principle of the PWM conditioning circuit is to compare an input reference voltage with a count value of the counter via the comparator, to control a duty cycle of a PWM signal.

The isolation drive circuit generally includes an input circuit, an isolation transformer, an output circuit, and the like. The input end receives the low-voltage control signal, and the isolation transformer isolates and amplifies the low-voltage control signal, and outputs the isolated and amplified control signal to the load circuit, for example, the power component.

FIG. 2 is a diagram of an isolation drive circuit. The isolation drive circuit generally includes an input circuit, an isolation transformer, an output circuit, and the like.

Input circuit: The input end is configured to receive a control signal, and the control signal is usually a digital signal generated by a control circuit, for example, a logic gate or a microprocessor.

Isolation transformer: The isolation transformer is a core part of the isolation drive circuit and is mainly configured to isolate an electrical signal between the input end and an output end. The isolation transformer generally includes two groups of coils on an input side and an output side.

Output circuit: The output end is configured to output a high-voltage drive signal, and transmit the signal to a thyristor SCR to control on/off of the thyristor, so as to implement on/off control of an electrical device in a load circuit.

A VCC in FIG. 2 is a common term in an electronic circuit, and usually represents a power supply voltage of the circuit. The VCC is a positive voltage provided by a direct current power supply or a battery, and is used to provide stable currents for various components and devices of the isolation drive circuit, to ensure that the circuit operates normally.

In a possible implementation, the output circuit further includes a drive conditioning circuit that has a signal conversion function, and may convert a control signal into a drive signal suitable for an electric mechanical device.

In an existing high-voltage isolation drive circuit, an isolation transformer needs to isolate and convert a low-voltage drive current signal input by an input end into a high-voltage drive current signal. For example, voltage transformation is performed in a manner in which a cable passes through a magnetic ring. In an isolation transformer shown in FIG. 3, an input cable 210 may be considered as a drive coil with one turn, and forms the transformer with a high-voltage magnetic ring 230. When the input cable passes through a magnetic ring, voltage transformation is generated in the magnetic ring. This function is referred to as magnetic ring voltage transformation effect. A principle of the magnetic ring voltage transformation effect is that a magnetic field is generated when a current in an input cable passes through a magnetic ring, and as a magnetic core, the magnetic ring has a high magnetic permeability and concentrates the magnetic field in the input cable in the magnetic ring, to generate the voltage transformation.

Specifically, the magnetic field is generated in the magnetic ring when the current on the input cable passes through the magnetic ring. The magnetic field generates a magnetic flux, and a value of the magnetic flux is in direct proportion to current intensity in the input cable. Because the magnetic ring has the high magnetic permeability, the magnetic field in the input cable is concentrated in the magnetic ring, to form the magnetic flux. When the magnetic flux changes, an induced electromotive force may be generated in the magnetic ring, which causes the voltage transformation. A magnitude of the voltage transformation is related to factors such as the current intensity in the input cable, the magnetic permeability of the magnetic ring, and an area of the magnetic ring. Therefore, when the input cable passes through the magnetic ring, the magnetic ring voltage transformation effect is generated.

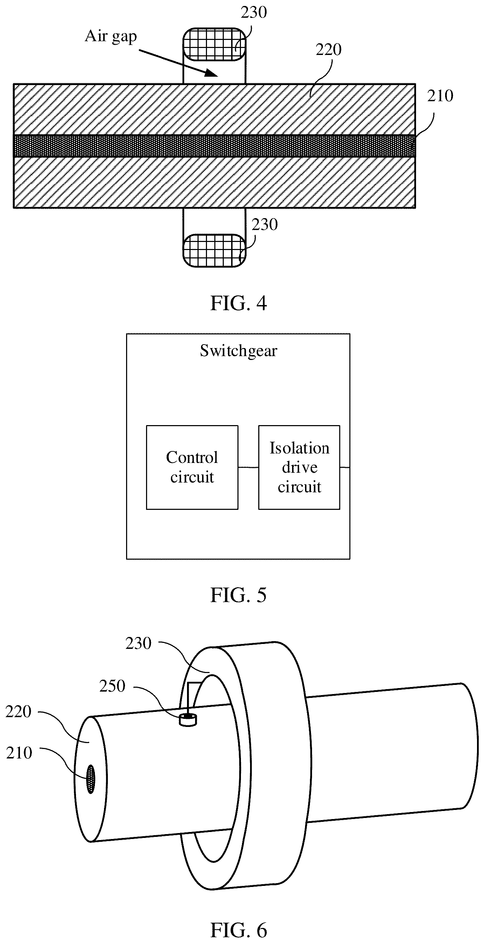

FIG. 4 is a sectional view of an isolation transformer along a cable axis. An input cable 210 is configured to receive a low-voltage drive current, a high-voltage magnetic ring 230 surrounds the input cable 210, and the magnetic ring 230 is configured to convert the low-voltage drive current in the input cable 210 into a high-voltage drive current, and control a power component, for example, a thyristor via the high-voltage drive current.

In the foregoing solution, the low-voltage current is isolated from the high-voltage current through an air gap between the cable insulation layer and the magnetic ring. In this manner, a cable with high insulation strength and wear resistance is usually required. In FIG. 4, the cable 210, an insulation layer 220, and the high-voltage magnetic ring 230 are included. The high-voltage magnetic ring 230 surrounds the cable 210 and there is an air gap between the high-voltage magnetic ring 230 and the cable 210. Because there is a high potential difference between the low-voltage cable 210 and the high-voltage magnetic ring 230, when an electric field in the air gap between the cable 210 and the high-voltage magnetic ring 230 is excessively large, air is ionized to generate partial discharge, which does not meet a standard requirement. In addition, the partial discharge damages the insulation layer of the cable, and there is a risk of insulation failure due to aging during long-term operation.

This application provides an insulation method and a structure of an isolation drive circuit. The insulation structure is disposed at a transformer module of the isolation drive circuit, to insulate a low-voltage input cable and a high-voltage magnetic ring in the transformer module. The low-voltage cable that passes through the high-voltage magnetic ring is potted in an insulation layer, and a shield net is embedded in the insulation layer, so that an electric field is distributed more evenly, and a partial discharge problem of an air gap between the high-voltage magnetic ring and the low-voltage cable is resolved.

The isolation drive circuit provided in this application is applicable to switches of various voltage levels in a complex environment, and is configured to control on/off of various electrical devices in a data center. The data center is a facility configured to store, process, manage, and transmit large-scale data. The isolation drive circuit provided in this application may be integrated into a switchgear of the data center.

FIG. 5 is a diagram of a switchgear (that is, a type of switch). The switchgear includes a control circuit and an isolation drive circuit (that is, a type of drive apparatus), and is configured to control on/off of an electrical device in a load circuit.

In a possible implementation, in addition to the control circuit and the isolation drive circuit, the switchgear may further include the following several circuits:
1. Logic control circuit: includes the foregoing control circuit, and the logic control circuit is mainly configured to control a logic control function in the switchgear, including starting/stopping, resetting, fault alarming, and the like. The logic control circuit generally includes a switch, a relay, a counter, and a clock.
2. Power supply circuit: The power supply circuit is mainly configured to supply power to each electrical device in the switchgear, including an alternating current power supply and a direct current power supply. The power supply circuit generally includes a transformer, a rectifier, a filter, a voltage regulator, and the like.
3. Communication circuit: The communication circuit is mainly configured to implement a communication function, including a manner of Ethernet, RS485, CAN, and the like, between the switchgear and another device. The communication circuit generally includes a communication module, a communication interface, and the like.
4. Protection circuit: The protection circuit is mainly configured to protect an electrical device in the switchgear from impact of overcurrent, overvoltage, and short-circuiting, including overload protection, short-circuiting protection, and current leakage protection. The protection circuit generally includes a protection component, a protection relay, and a protection switch.

The following describes several isolation drive circuits disposed in the switchgear.

FIG. 6 is a diagram of an isolation drive circuit and an insulation structure of the isolation drive circuit according to this application.

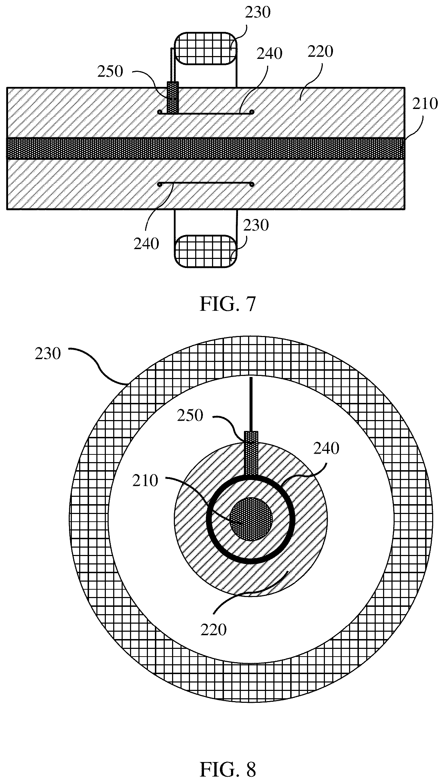

FIG. 7 is a sectional view of an isolation drive circuit and an insulation structure of the isolation drive circuit along a cable axis.

FIG. 8 is a sectional view of an isolation drive circuit and an insulation structure of the isolation drive circuit at a high-voltage magnetic ring along a cross section of a cable.

Specifically, as shown in FIG. 6, FIG. 7, and FIG. 8, the isolation drive circuit includes a low-voltage cable 210 and a high-voltage magnetic ring 230 wound with a coil. The low-voltage cable 210 is an input end, and the wound coil on the high-voltage magnetic ring is an output end. There is an air gap between the low-voltage cable 210 and the wound coil, to isolate the input end and the output end, and implement voltage transformation between the input end and the output end. The input end provides a low-voltage signal and a low-current signal via a control circuit, and the output end is usually connected to a high-voltage load and a switch component (for example, a thyristor), and needs to provide an isolation voltage signal and an isolation current signal. The low-voltage input cable and the output wound coil are coupled to each other, and a voltage of the output coil may change with that of the input cable, thereby implementing voltage transformation.

In this embodiment of this application, in addition to the thyristor, a power component that may be used as a switch component further includes a triode, a metal-oxide semiconductor field effect transistor, an insulated gate bipolar transistor IGBT, a relay, or the like. All these power components can adjust currents and voltages of electrical devices according to changing of a control signal, to implement on/off control of the electrical devices. The power component needs to be selected and applied based on a specific control requirement and an operating environment, and is properly designed and combined, to meet a control requirement and a safety requirement of the switchgear.

There are two ways of winding the coil on the magnetic ring: single-layer winding and multi-layer winding. Single-layer winding means that each turn of the coil is wound on a same plane of the magnetic ring. Two ends of the coil are adjacent and do not cross through each other. This winding method can increase a number of turns of the coil on the magnetic ring, thereby improving an inductance value and magnetic field strength of the coil. However, because each turn of the coil is on the same plane, space utilization of the coil is low. Multi-layer winding means that each layer of the coil is wound on different planes of the magnetic ring, and two ends of the coil are not adjacent and cross through each other. This winding method can increase a number of turns of the coil on the magnetic ring, thereby improving an inductance value and magnetic field strength of the coil, and improving space utilization of the coil. However, large space needs to be reserved on the magnetic ring for multi-layer winding, and crossing-through of the coil increases capacitance of the coil, resulting in changing of a circuit parameter. In actual application, whether to select single-layer winding or multi-layer winding depends on a specific application requirement. If a high inductance value and high magnetic field strength are required, single-layer winding can be selected. If high space utilization is required, multi-layer winding can be selected. In addition, to reduce the capacitance of the coil, measures such as mixing the winding methods or winding a plurality of turns of insulation tapes may be used to limit crossing-through of the coil.

Generally, to improve insulation performance between the cable and the magnetic ring, a distance of the air gap may be increased, for example, a thickness of an insulation layer is increased or a distance between the cable and the magnetic ring is increased. This makes a size of the isolation drive apparatus large, and reduces power density.

The isolation drive circuit provided in this application performs isolation via the insulation layer and a conductive shield net packaged inside the insulation layer. The insulation layer wraps a surface of the cable and there is an air gap between the insulation layer and the magnetic ring. The shield net surrounds the cable and is embedded in the insulation layer between the magnetic ring and the cable, and the shield net is equipotentially connected to the magnetic ring through a conducting wire.

It should be understood that both the cable and the magnetic ring are fastened in the switchgear, to ensure that there is a gap between the cable and the magnetic ring.

The cable and magnetic ring are fastened in different ways in the switchgear. The details are as follows:
1. Cable fastening mode: A cable is usually fastened to a cable trough or a terminal board of the switchgear through a terminal slot or a wiring terminal, and may be fastened via a fastener, for example, a screw or a clip. The fastener to be selected requires the specifications and model corresponding to specifications and requirements of the cable, to ensure that the fastener is securely fastened.
2. Magnetic ring fastening mode: A magnetic ring is usually fastened on a magnetic ring support of the switchgear via a magnetic ring holder or a magnetic ring clip. The magnetic ring holder is generally an elastic metal sheet, and can clip the magnetic ring onto the magnetic ring support, to ensure that a position of the magnetic ring is accurate and stable. The magnetic ring clip is also a common fastening manner, and can clip the magnetic ring onto the magnetic ring support, to ensure that the magnetic ring does not move. The magnetic ring holder or the magnetic ring clip to be selected requires specifications and model corresponding to specifications and requirements of the magnetic ring, to ensure that the magnetic ring is securely fastened.

The shield net is a structure used for electromagnetic shielding, and is mainly used to prevent electromagnetic radiation and electromagnetic induction. The shield net is usually made of a conductive material, for example, a metal mesh, a metal foil, and a copper foil, and has good conductivity and shielding performance. Many factors, such as selection of a shielding material, designing of a mesh structure, a grounding mode, and the like, need to be considered during designing and manufacturing of the shield net. Different application scenarios and requirements require different shield net structures and manufacturing techniques to achieve optimal shielding effect. In conclusion, the shield net is a very important electronic shield structure, which can effectively suppress electromagnetic radiation and electromagnetic induction, and ensure normal operation of a device and stable transmission of a signal.

As shown in FIG. 7, the shield net is located inside the insulation layer, and surrounds the cable at a first position. The first position is a position at which the cable passes through the magnetic ring, that is, a position at which a projection of the magnetic ring on the cable is located. The cable passes through the shield net.

It should be noted that the shield net does not contact the surface of the cable, and a distance needs to be kept between the shield net and the surface of the cable. Otherwise, short-circuiting occurs, and the shield net loses a shielding function.

In addition, a width of the shield net in an axis direction of the cable is greater than a width of the magnetic ring in the axis direction of the cable, and a projection area of the shield net on the cable can fully cover a projection area of the magnetic ring on the cable.

A mesh shape and density of the shield net affect shielding effect of the shield net. Generally, the mesh shape and density of the shield net need to be selected based on a frequency range of electromagnetic waves that are to be shielded and a requirement of shielding effect.

For shielding of a low-frequency electromagnetic wave, the mesh may use a wide mesh spacing and a large mesh size, to fully shield the low frequency electromagnetic wave. For shielding of a high-frequency electromagnetic wave, the mesh needs to use a narrow mesh spacing and a small mesh size, to fully shield the high-frequency electromagnetic wave.

In addition, the shape of the mesh also affects shielding effect. Generally, the mesh shape of the shield net may be a square, a hexagon, a circle, or the like, and different mesh shapes affect shielding effect of the shield net in different directions. For meshes with same density, a hexagonal mesh is easier to form coverage than a square mesh, thereby achieving better shielding effect.

It should be understood that after the shield net is connected to the magnetic ring through a conducting wire, the shield net and the magnetic ring are equipotential. In this case, a voltage of the shield net is the same as that of the high-voltage magnetic ring. Because the shield net is located in the insulation layer, electric field strength between the shield net and the magnetic ring is reduced, that is, electric field strength of an air gap and the insulation layer and that is outside the shield net is reduced, so that air is not broken down by a high-strength electric field, which reduces partial discharge.

In this application, the shield net needs to be embedded in the insulation layer of the insulation structure, and stability and reliability of the circuit further need to be ensured. Epoxy resin is a common insulation material, which is often used as an insulation layer in an electrical device and an electronic component. Epoxy resin has advantages of good insulation, high mechanical strength, good heat resistance, and strong chemical stability, and is widely used in the electrical device and the electronic component.

It should be understood that a thickness of the insulation layer is greater than a distance between the shield net and the surface of the cable. That is, the thickness of the insulation layer needs to ensure that the shield net can be fully wrapped.

In a possible implementation, the insulation layer is formed by potting epoxy resin, and has advantages of a small size, a reasonable functional structure of harmonic elimination, easy installation, stable insulation, a small partial discharge capacity, safe operation, and easy maintenance, and may be widely matched with a new type of switchgear.

Epoxy resin potting is a common electronic packaging process, which is mainly used to seal and protect an electronic component and a circuit board. Epoxy resin potting has the following advantages:
1. Protect the electronic component: Epoxy resin potting can wrap the electronic component and a circuit board to protect them from mechanical and physical damage, such as vibration, impact, and humidity, thereby improving reliability of the electronic component and prolonging a service life of the electronic component.
2. Improve electrical performance: Epoxy resin potting can improve voltage resistance, arc resistance, and heat resistance of the electronic component, thereby reducing a failure rate and maintenance costs of the electronic component.
3. Improve an appearance of the electronic component: Epoxy resin potting can make a surface of the electronic component smooth and beautiful, thereby improving grade and quality of a product.
4. Implement water resistance and dust resistance: Epoxy resin potting can prevent water and dust from entering the electronic component, thereby ensuring normal operation and long-term stability of the electronic component.

A processing process of epoxy resin potting includes preparation, mixture preparation, potting, curing, and the like. During specific operation, epoxy resin and a curing agent are first mixed evenly according to a proportion, and then the mixture is poured into a potting mold to fill the entire mold, and is finally cured at a temperature, so that epoxy resin becomes a hard sealing body.

In conclusion, epoxy resin potting is an important electronic packaging process, can improve reliability of the electronic component and prolong a service life of the electronic component, improve an appearance of the electronic component, achieve advantages such as water resistance and dust resistance, and therefore is widely applied to various electronic devices and circuit boards.

In an isolation drive circuit in which the cable passes through a plurality of magnetic ring coils, an electric field in an air gap between the cable and the magnetic ring is more complex, and a problem of excessively high electric field strength also exists between the cable and the high-voltage magnetic ring. In this case, the insulation structure provided in the foregoing solution is also applicable to the isolation drive circuit in which the cable passes through the plurality of magnetic ring coils.

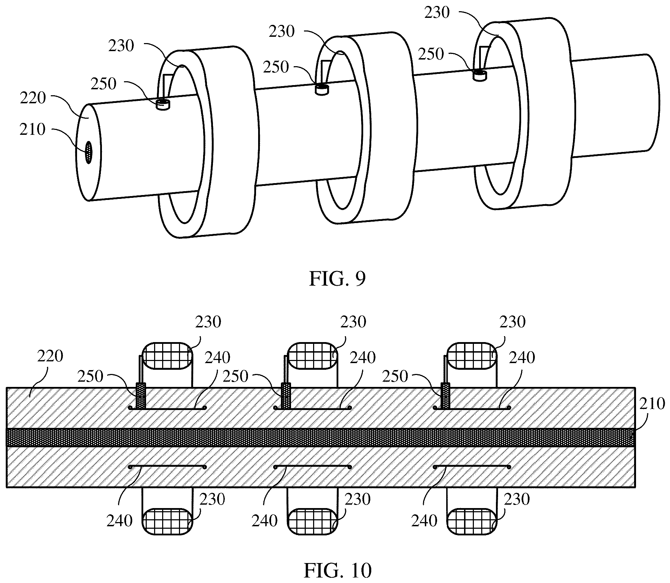

FIG. 9 is a diagram of another isolation drive circuit and an insulation structure of the another isolation drive circuit.

FIG. 10 is a sectional view of an isolation drive circuit and an insulation structure of the isolation drive circuit along a cable axis.

As shown in FIG. 9 and FIG. 10, the foregoing insulation structure may be disposed between each magnetic ring coil and a cable.

The insulation structure includes an insulation layer and a plurality of conductive shield nets packaged inside the insulation layer, where the plurality of shield nets one-to-one correspond to a plurality of magnetic rings, each shield net is embedded in an insulation layer between a corresponding magnetic ring and the cable, and surrounds the cable, and the shield net is equipotentially connected to the corresponding magnetic ring through a conducting wire. The insulation layer wraps a surface of the cable and there is a gap between the insulation layer and the magnetic ring.

It should be understood that after the shield net is connected to the corresponding magnetic ring through the conducting wire, the shield net and the magnetic ring are equipotential. In this case, a voltage of the shield net is the same as that of the high-voltage magnetic ring. Because the shield net is located in the insulation layer, electric field strength between the shield net and the magnetic ring is reduced, that is, electric field strength of an air gap and the insulation layer and that is outside the shield net is reduced, so that air is not broken down by a high-strength electric field, which reduces partial discharge.

The isolation drive circuit is insulated according to the insulation method in this application, so that insulation performance can be effectively improved. The improvement of the insulation performance helps reduce a size of the isolation drive apparatus and increase power density.

In the foregoing solution, when the cable passes through the plurality of magnetic rings, a plurality of shield nets need to be installed. The following steps may be performed:
1. Determine a position of each magnetic ring to determine a quantity of required shield nets.
2. Adjust a size of each shield net to a proper size to ensure that each magnetic ring can be fully covered.
3. Sleeve each shield net on a conducting wire and connect the shield net at a position of each magnetic ring to shield interference, where a distance between the shield net and the cable needs to be proper to avoid short-circuiting.
4. Use epoxy resin for potting, and evenly apply a layer of epoxy resin to a cable at the position of each magnetic ring, and wrap the conducting wire and shield net with the resin to ensure that the resin fully covers the conducting wire and shield net.
5. Before the epoxy resin is dried and cured, check whether the conducting wire and the shield net are fully wrapped and whether there is a defect, for example, a bubble.
6. Wait for the epoxy resin to be dried and cured, where time depends on a type and a thickness of the epoxy resin.
7. Check installation effect to ensure that the shield net can effectively shield interference from a magnetic field, and the epoxy resin can play an insulation role.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A switch, comprising:
a control circuit, configured to generate a low-voltage drive current; and
a drive apparatus, comprising:
a cable, configured to transmit the low-voltage drive current;
at least one magnetic ring, wherein each magnetic ring is wound with a coil, the cable passes through the at least one magnetic ring, there is a gap between the magnetic ring and the cable, and the magnetic ring is configured to generate a high-voltage drive current based on the low-voltage drive current in the cable;
an insulation layer, configured to wrap the cable;
at least one shield structure, configured to shield an electromagnetic wave, wherein the at least one shield structure one-to-one corresponds to the at least one magnetic ring, the shield structure is embedded in the insulation layer, each shield structure is located between a corresponding magnetic ring and the cable, the shield structure and the cable are not in contact with each other, and there is the insulation layer between the shield structure and the cable; and
a power component, configured to switch between turning-on and turning-off based on the high-voltage drive current.

2. The switch according to claim 1, wherein the shield structure is equipotentially connected to the corresponding magnetic ring through a conducting wire.

3. The switch according to claim 1 or 2, wherein a width of the shield structure in an axis direction of the cable is greater than a width of the magnetic ring in the axis direction of the cable.

4. The switch according to any one of claims 1 to 3, wherein a projection of the magnetic ring on the cable is within a projection of the shield structure on the cable.

5. The switch according to any one of claims 1 to 4, wherein the shield structure is an annular shield net made of a conductive metal material, and the shield structure surrounds the cable.

6. The switch according to any one of claims 1 to 5, wherein the power component is a thyristor, a triode, a metal-oxide semiconductor field effect transistor, an insulated gate bipolar transistor, or a relay.

7. A drive apparatus, configured to control turning-on and turning-off of a power component, and comprising:
a cable, configured to transmit a low-voltage drive current;
at least one magnetic ring, wherein each magnetic ring is wound with a coil, the cable passes through the at least one magnetic ring, there is a gap between the magnetic ring and the cable, and the magnetic ring is configured to generate a high-voltage drive current based on the low-voltage drive current in the cable;
an insulation layer, configured to wrap the cable;
at least one shield structure, configured to shield an electromagnetic wave, wherein the at least one shield structure one-to-one corresponds to the at least one magnetic ring, the shield structure is embedded in the insulation layer, and each shield structure is located between a corresponding magnetic ring and the cable; and
a power component, configured to switch between turning-on and turning-off based on the high-voltage drive current.

8. The drive apparatus according to claim 7, wherein the shield structure is equipotentially connected to the corresponding magnetic ring through a conducting wire.

9. The drive apparatus according to claim 7 or 8, wherein a width of the shield structure in an axis direction of the cable is greater than a width of the magnetic ring in the axis direction of the cable.

10. The drive apparatus according to any one of claims 7 to 9, wherein a projection of the magnetic ring on the cable is within a projection of the shield structure on the cable.

11. The drive apparatus according to any one of claims 7 to 10, wherein the shield structure is an annular shield net made of a conductive metal material, and the shield structure surrounds the cable.

12. The drive apparatus according to any one of claims 7 to 11, wherein the power component is a thyristor, a triode, a metal-oxide semiconductor field effect transistor, an insulated gate bipolar transistor, or a relay.

13. A data center, comprising the switch according to any one of claims 1 to 6 and an electronic component controlled by the switch.
